(19) Europäisches Patentamt
European Patent Office
Office européen des brevets

(11) EP 1 063 283 B1

(12) # FASCICULE DE BREVET EUROPEEN

(45) Date de publication et mention de la délivrance du brevet:
**22.12.2004 Bulletin 2004/52**

(51) Int Cl.[7]: **C11D 17/00**, C11D 1/12, C11D 3/43, C11D 3/20, C11D 3/18

(21) Numéro de dépôt: **00401766.1**

(22) Date de dépôt: **21.06.2000**

(54) **Compositions de nettoyage à froid du type microémulsions**

Kaltreiniger in Form einer Mikroemulsion

Cold cleaning microemulsion compositions

(84) Etats contractants désignés:
**AT BE CH CY DE DK ES FI FR GB GR IE IT LI LU MC NL PT SE**

(30) Priorité: **21.06.1999 FR 9907848**

(43) Date de publication de la demande:
**27.12.2000 Bulletin 2000/52**

(73) Titulaire: **Atofina**
**92800 Puteaux (FR)**

(72) Inventeurs:
- **Michaud, Pascal**
**95210 Saint-Gratien (FR)**
- **Martin, Jean-Jacques**
**92270 Bois-Colombes (FR)**
- **Brochette, Pascal**
**56200 La Gacilly (FR)**

(74) Mandataire: **Chaillot, Geneviève**
**Cabinet CHAILLOT,**
**16-20, avenue de L'Agent Sarre,**
**B.P. 74**
**92703 Colombes Cédex (FR)**

(56) Documents cités:
**EP-A- 0 216 355**
**EP-A- 0 418 986**
**WO-A-99/06520**
**FR-A- 2 119 274**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).



Printed by Jouve, 75001 PARIS (FR)

## Description

La présente invention porte sur une composition de nettoyage, du type microémulsion, utilisable notamment pour le nettoyage à froid (c'est-à-dire à la température ambiante) de surfaces de pièces métalliques, de céramiques, de verres, de matières plastiques, de circuits imprimés, etc.

Traditionnellement, ces surfaces étaient nettoyées au 1,1,1-trichloroéthane, solvant très polyvalent, mais qui a été condamné par le protocole de Montréal en raison de son impact sur la couche d'ozone.

Il a été trouvé que l'on pouvait alors utiliser des compositions dites microémulsions, lesquelles permettent à la fois le nettoyage des salissures minérales et organiques, car elles combinent une partie solvant organique et une partie aqueuse. La partie aqueuse est en général conséquente et renferme un agent tensio-actif. Les microémulsions apparaissent comme étant des solutions transparentes, stables thermodynamiquement, facilement préparables. Ceci s'explique grâce à la teneur élevée en tensio-actif qui permet leur formation en grand nombre. Selon l'hydrocarbure utilisé (de la phase solvant organique), une plage de stabilité ou un intervalle de stabilité de la microémulsion avec la température peut être relativement étroit (10 à 15°C), ce qui peut être gênant au stockage ou selon les conditions d'utilisation, car la microémulsion peut se séparer en les deux phases : partie aqueuse/partie solvant organique.

Ainsi, les microémulsions actuellement disponibles sur le marché ne manifestent pas l'efficacité attendue et présentent une instabilité à la température lorsqu'on atteint les 35°C.

La Société déposante a cherché à remédier à cet inconvénient et donc à augmenter la plage de stabilité en température des microémulsions avec une viscosité basse pour l'utilisation à froid. Ceci lui a permis de découvrir que des agents tensio-actifs particuliers pouvaient abaisser la viscosité des solvants à haut point d'ébullition, en vue de leur utilisation à froid, facilitant leur utilisation sans avoir l'obligation de réchauffer l'ensemble (économie d'énergie) et permettant de se dégager de la réglementation sur les composés organiques volatils (dits COV) si le taux de solvant est inférieur à 30% en poids de la composition.

WO-A-99/06520 décrit une émulsion comprenant de l'eau, un hydrocarbure fonctionnalisé tel qu'un mélange d'adipate/ glutanate/succinate de diméthyle, un agent tensio-actif de type sullosuccinate et un diol.

La présente invention a donc pour objet une composition de nettoyage se présentant sous la forme d'une microémulsion stable à la température ambiante, ladite composition comprenant :

(A) de l'eau ;
(B) au moins un solvant organique liquide à la température ambiante ; et
(C) au moins un agent tensio-actif,

caractérisée par le fait que :

(A) représente de 30 à 70 parties en poids, en particulier 35 à 60 parties en poids ;
(B) représente de 20 à 60 parties en poids, en particulier 25 à 55 parties en poids ; et
(C) représente de 5 à 30 parties en poids, en particulier 10 à 25 parties en poids

(A) + (B) + (C) représentant 100 parties en poids ; et le ou les solvants organiques (B) étant choisis parmi :

(4) les hydrocarbures aliphatiques ;
(5) les hydrocarbures aliphatiques halogénés ;
(6) les hydrocarbures aromatiques ;
(9) les monoéthers des alkylène glycols, des dialkylène glycols et des trialkylène glycols ;
(10) les diéthers des (di)alkylène glycols ; et
(11) les éther acétates des (di)alkylène glycols ; et

une partie du constituant (B) étant constituée par au moins l'un parmi les éthers dés familles (9), (10) et (11); et le ou les agents tensio-actifs (C) étant choisis parmi ceux de la formule (I) :

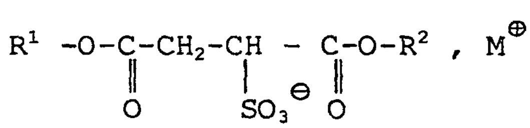

(I)

dans laquelle :

- $R^1$ et $R^2$ représentent chacun indépendamment un radical alkyle; linéaire ou ramifié, en $C_5$-$C_{20}$ ;
- M est un cation choisi parmi $Na^{\oplus}$, $K^{\oplus}$ et $NR_4^{\oplus}$, les R représentant chacun indépendamment hydrogène ou un radical alkyle en $C_1$-$C_4$.

Les solvants (1), (2), (3), (7), (8) ci-après ne sont pas des solvants (B) selon l'invention.

(1) Les alcools aliphatiques peuvent être des alcools primaires, secondaires ou tertiaires. Ils ont notamment de 4 à 24 atomes de carbone. A titre d'exemples de ces alcools, on peut citer l'octanol, le 2-éthyl-hexanol, le nonanol, le dodécanol, l'undécanol et le décanol.

(2) Les esters aliphatiques ont notamment de 4 à 24 atomes de carbone. A titre d'exemples de ces esters, on peut citer le laurate de méthyle, l'oléate de méthyle, les acétates d'hexyle, les acétates de pentyle, les acétates d'octyle, les acétates de nonyle et les acétates de décyle, les lactates de méthyle, d'éthyle, de propyle, de butyle, d'hexyle.

(3) Les diesters aliphatiques contiennent notamment 6 à 24 atomes de carbone. A titre d'exemples, on peut citer l'adipate de diméthyle, le succinate de diméthyle, le glutarate de diméthyle, l'adipate de diisobutyle, et le maléate de diisobutyle.

(4) Les hydrocarbures aliphatiques peuvent être des hydrocarbures linéaires, ramifiés, cycliques ou leurs combinaisons. Ils contiennent notamment de 3 à 24 atomes de carbone, de préférence 6 à 24 atomes de carbone. A titre d'exemples de ces hydrocarbures aliphatiques, on peut citer les alcanes, tels que le propane liquide, le butane, l'hexane, l'octane, le décane, le dodécane, l'hexadécane, les huiles minérales, les huiles paraffiniques, le décahydronaphtalène, le bicyclohexane, le cyclohexane, et les oléfines telles que le 1-décène, le 1-dodécène, l'octadécène et l'hexadécène. Des exemples d'hydrocarbures aliphatiques disponibles dans le commerce sont :

- les NORPAR™ 12, 13 et 15 (solvants paraffiniques normaux disponibles auprès de la Société "EXXON CORPORATION") ;
- les ISOPAR™ G, H, K, L, M, V (solvants isoparaffiniques disponibles auprès de la Société "EXXON CORPORATION") ;
- les solvants SHELLSOL™ (disponibles auprès de la Société "SHELL CHEMICAL COMPANY") ;
- les PETROSOLV™ de CEPSA D-15/20, D-19/22, D-20/26, D-24/27, D-28/31 (solvants paraffiniques et isoparaffiniques disponibles auprès de la Société "CEPSA") ; et
- les solvants hydrocarbonés EXXSOL™ commercialisés par la Société "EXXON CORPORATION".

(5) Les hydrocarbures aliphatiques halogénés, notamment chlorés, contiennent 1 à 12, en particulier 2 à 6 atomes de carbone. A titre d'exemples de ces hydrocarbures aliphatiques chlorés, on peut citer le chlorure de méthylène, le tétrachlorure de carbone, le chloroforme, le 1,1,1-trichloroéthane, le perchloroéthylène et le trichloroéthylène.

(6) Les hydrocarbures aromatiques contiennent notamment 6 à 24 atomes de carbone. A titre d'exemples de ces hydrocarbures aromatiques, on peut citer le toluène, le naphtalène, le biphényle, l'éthyl benzène, le xylène, et les alkyl benzènes tels que le dodécyl benzène, l'octyl benzène et le nonyl benzène.

(7) Les cétones aliphatiques ont notamment 4 à 24 atomes de carbone. A titre d'exemples de ces cétones, on peut citer la méthyl éthyl cétone, la diéthyl cétone, la diisobutyl cétone, la méthyl isobutyl cétone et la méthyl hexyl cétone.

(8) Les éthers aliphatiques contiennent notamment 4 à 24 atomes de carbone. A titre d'exemples, on peut citer l'éther diéthylique, l'éthyl propyl éther, l'éther hexylique, l'éther butylique, et le méthyl t-butyl éther.

(9)

(a) Les monoéthers des alkylène glycols sont notamment :

- les monoéthers du propylène glycol en $C_4$-$C_{25}$, tels que l'éther monométhylique du propylène glycol (PM), l'éther monoéthylique du propylène glycol (PE), l'éther mono-n-propylique du propylène glycol (PNP), l'éther mono-tert.- butylique du propylène glycol (PTB), l'éther mono-n-butylique du propylène glycol (PNB) et l'éther mono-hexylique du propylène glycol ;

- les monoéthers de l'éthylène glycol en $C_3$-$C_{25}$, tels que l'éther hexylique de l'éthylène glycol, l'éther octylique de l'éthylène glycol et l'éther phénylique de l'éthylène glycol.

(b) Les monoéthers des dialkylène glycols sont, par exemple :

- l'éther monométhylique du dipropylène glycol (DPM), l'éther mono-n-propylique du dipropylène glycol (DPNP), l'éther mono-tert.-butylique du dipropylène glycol (DPTB), l'éther mono-n-butylique du dipropylène glycol (DPNB) et l'éther monohexylique du dipropylène glycol ; et
- l'éther n-butylique du diéthylène glycol (Butyl Diglycol Ether - BDG), l'éther hexylique du diéthylène glycol et l'éther octylique du diéthylène glycol.

(c) Les monoéthers des trialkylène glycols sont par exemple : l'éther monométhylique du tripropylène glycol (TPM) et l'éther mono-n-butylique du tripropylène glycol (TPNB).

(10)

(a) Les diéthers des alkylène glycols sont notamment :

- les diéthers du propylène glycol en $C_5$-$C_{25}$, tels que l'éther diméthylique du propylène glycol ; le benzyl méthyl éther du propylène glycol ; le butyl méthyl éther du propylène glycol ; et l'éther dibutylique du propylène glycol ;

- les diéthers de l'éthylène glycol en $C_4$-$C_{25}$, tels que l'éther diéthylique de l'éthylène glycol ; et l'éther dibutylique de l'éthylène glycol.

(b) Les diéthers des dialkylène glycols sont, par exemple, l'éther diméthylique du dipropylène glycol, le butyl méthyl éther du dipropylène glycol et l'éther dibutylique du dipropylène glycol.

Comme exemples de solvants appartenant à ces familles (9) et (10), on peut citer les solvants "ARCOSOLV" de la Société "ARCO CHEMICAL" et "DOWANOL" de la Société "DOW CHEMICAL COMPANY" : PM, PE, PNP, PTB, PNB, DPNP, DPTB, DPNB, TPM et TPNB.

(11)

(a) Les éther acétates des alkylène glycols sont notamment :

- les éther acétates du propylène glycol en $C_5$-$C_{25}$, tels que le méthyl éther acétate du propylène glycol (PM ACETATE) ; l'éthyl éther acétate du propylène glycol (PE ACETATE) et le butyl éther acétate du propylène glycol ; et

- les éther acétates de l'éthylène glycol en $C_4$-$C_{25}$, tels que l'éthyl éther acétate de l'éthylène glycol ; et le butyl éther acétate de l'éthylène glycol.

(b) Les éther acétates des dialkylène glycols sont, par exemple, le méthyl éther acétate du dipropylène glycol (DPM ACETATE) et le butyl éther acétate du diéthylène glycol.

Comme exemples de solvants appartenant à cette famille (11), on peut citer les solvants "ARCOSOLV" et "DOWANOL" PM ACETATE, PE ACETATE et DPM ACETATE.

A titre de solvants organiques préférés, on peut citer les hydrocarbures aliphatiques, les hydrocarbures aromatiques, les monoéthers des alkylène glycols, les monoéthers des dialkylène glycols, les monoéthers des trialkylène glycols, les diéthers des alkylène glycols, les diéthers des dialkylène glycols, les éther acétates des alkylène glycols et les éthers acétates des dialkylène glycols.

Les éthers des familles (9), (10) et (11) peuvent également jouer le rôle de co-tensio-actifs. C'est pourquoi on peut avantageusement préparer une formulation qui les contient en une quantité inférieure à l'autre solvant (B) ou aux autres solvants (B), cette quantité pouvant également - mais ce n'est pas une obligation - être inférieure à la quantité d'agent tensio-actif (A).

La composition selon l'invention peut en outre contenir :

- au moins un agent séquestrant, tel que l'acide éthylène diamine tétra acétique (EDTA) et ses sels, à raison notamment de 0,01 à 0,1 partie en poids pour 100 parties en poids de (A) + (B) + (C) ; et/ou
- au moins un agent chélatant, choisi notamment parmi les éthers couronnes, à raison notamment de 0,01 à 0,1 partie en poids, pour 100 parties en poids de (A) + (B) + (C); et/ou
- au moins un agent anti-corrosion choisi notamment parmi les acides organiques de type R°-COOH, R° étant un radical hydrocarboné en $C_4$-$C_{24}$, et les amines, à raison notamment de 0,01 à 0,5 partie en poids pour 100 parties en poids de (A) + (B) + (C); et/ou
- au moins un additif, dans les quantités usuelles, choisi parmi les désinfectants, les fongicides (sels d'ammonium quaternaires) et les biocides (peroxydes organiques, peroxyde d'hydrogène, composés à halogène actif, sels inorganiques phénoliques, sels d'ammonium quaternaires, dérivés organométalliques, dérivés organosoufrés) ; et/ou
- au moins un parfum.

On prépare les microémulsions selon l'invention en mélangeant les constituants dans un ordre indifférent à température ambiante. Le point ou facteur essentiel est de se trouver dans la plage de stabilité de la microémulsion, cette plage étant déterminée par une simple mesure de la température. A partir de cette donnée, l'addition de tous les ingrédients dans un ordre ou dans un autre conduira à la formation rapide de la microémulsion.

Pour l'utilisation, les microémulsions selon l'invention sont appliquées sur les surfaces à nettoyer à l'aide d'un pinceau ou d'un chiffon. Selon la nature de l'application et des opérations postérieures, un rinçage à l'eau pourra être nécessaire.

Les Exemples suivants illustrent la présente invention sans toutefois en limiter la portée. Dans ces Exemples, les ingrédients utilisés étaient les suivants :

Solvants

| | |
|---|---|
| Solvant n°1 = | Solvant isoparaffinique commercialisé par la Société "EXXON CORPORATION" sous la dénomination "ISOPAR™ H" |
| Solvant n°2 = | Solvant hydrocarboné commercialisé par la Société "EXXON CORPORATION" sous la dénomination "EXXSOL D 100S" |
| Solvant n°3 = | Solvant hydrocarboné commercialisé par la Société "CEPSA" sous la dénomination "PETROSOLV D 20/26" |
| Solvant n°4 = | Solvant hydrocarboné commercialisé par la Société "CEPSA" sous la dénomination "PETROSOLV D 24/27" |
| Solvant n°5 = | Solvant hydrocarboné commercialisé par la Société "CEPSA" sous la dénomination "PETROSOLV D 28/31" |

Co-solvants

- BDG = Butyl Diglycol Ether ou 2-(2-Butoxyéthoxy)éthanol commercialisé par la Société "B.P. Chimie"
- PNB = éther n-butylique du propylène glycol, commercialisé sous la dénomination "DOWANOL™ PNB" par la Société "THE DOW CHEMICAL COMPANY"
- DPNB = éther n-butylique du dipropylène glycol, commercialisé sous la dénomination "DOWANOL™ DPNB" par la Société "THE DOW CHEMICAL COMPANY"
- PTB = éther mono- tert.-butylique du propylène glycol, commercialisé sous la dénomination "ARCOSOLV PTB" par la Société "ARCO".

Agent tensio-actif

L'agent tensio-actif utilisé est le composé de formule :

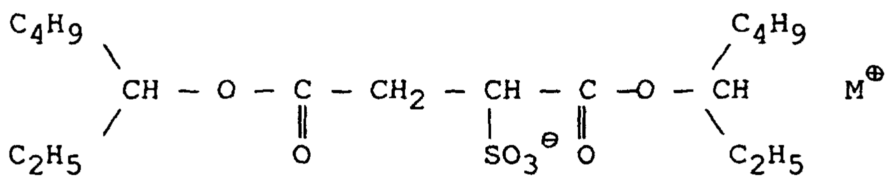

$M^{\oplus} = Na^{\oplus}$

commercialisé par la Société "ALBRIGTH & WILSON IBERICA" sous la dénomination "EMPIMIN OP 070".

Dans ces Exemples, toutes les proportions citées sont en parties en poids.

EXEMPLES DE PRÉPARATION 1 à 10

Mode opératoire général

Dans un Erlenmeyer de 500 ml, on prépare, sous agitation, 400 g d'une micro-émulsion en mélangeant à la température ambiante les ingrédients dans les proportions indiquées dans le Tableau 1 ci-après. Le mélange est instantané et la formulation obtenue est complètement transparente.

TABLEAU 1

| Exemple / Composition | 1 | 2 | 3 | 4 | 5 | 6 | 7 | 8 | 9 | 10 |
|---|---|---|---|---|---|---|---|---|---|---|
| Eau | 40 | 35 | 40 | 39 | 37 | 42 | 42 | 37 | 37 | 42 |
| Solvant n°1 | 40 | .. | 40 | 39 | | | | | | |
| Solvant n°2 | .. | 35 | .. | .. | 37 | | | | | |
| Solvant n°3 | .. | .. | .. | .. | .. | 30 | 33 | | | |
| Solvent n °4 | .. | .. | .. | .. | .. | .. | .. | 28 | | |
| Solvant n°5 | .. | .. | .. | .. | .. | .. | .. | .. | 20 | 23 |
| BDG ...... | .. | .. | 2 | | | | | | | |
| PNB ....... | .. | .. | .. | .. | .. | 13 | .. | .. | 8 | |
| DPNB ...... | .. | .. | .. | 8 | 8 | .. | .. | .. | 10 | 20 |
| PTB ....... | .. | .. | .. | .. | .. | .. | 10 | 10 | | |
| Tensio-actif | 20 | 25 | 18 | 14 | 18 | 15 | 15 | 25 | 25 | 15 |

EXEMPLE D'ESSAI 11

Protocole d'essai

Sur une grille en inox de 5 x 5 cm en forme de cylindre, suspendue, on badigeonne à la brosse environ 2 g d'une salissure constituée de :

| | |
|---|---|
| Huile moteur (PLANETELF ACD 32) | 28,5 |
| Huile de pompe (OLEOFLUX CPO AC) | 28,5 |
| Graisse EQUATEUR ROSE | 14,3 |
| Sable de Fontainebleau | 14,3 |
| Poudre de charbon | 14,4 |
| | 100 |

Cet ensemble est pesé précisément.

La grille ainsi préparée est immergée dans 100 ml de la microémulsion à évaluer. Après 1, 5, 10, 15 minutes, la grille est pesée, ce qui permet de suivre la perte de salissure (efficacité), exprimée en % en poids, enlevée par le solvant.

Résultats

Les efficacités obtenues avec les compositions des Exemples 3 et 6 et de deux microémulsions comparatives du commerce ME1 et ME2 sont présentées dans le Tableau 2 ci-après.

TABLEAU 2

| Efficacité (%) | Temps (min.) | | | |
|---|---|---|---|---|
| Composition de l'Exemple | 1 | 5 | 10 | 15 |
| 3 | 7 | 51 | 89 | 97 |
| 6 | 2 | 34 | 70 | 93 |
| ME1* | 0 | 12 | 48 | 79 |
| ME2** | 0 | 2 | 36 | 61 |

* ME1: Microémulsion composée essentiellement, en % en poids, de :

- 15% d'hydrocarbures aliphatiques ;
- 15% d'éther mono-n-butylique du propylène glycol ; - 15% d'éther mono-n-propylique du dipropylène glycol ;
- 5% d'un mélange de dodécylbenzène sulfonate de sodium et d'un mélange d'eicosanoyl benzène sulfonate de sodium, de tétracosanoyl benzène sulfonate de sodium ; et
- 50% d'eau.

** ME2: Microémulsion composée essentiellement, de :

- 10% de DL-limonène ;
- 40% d'éther de glycol ;
- 10% de dodécylbenzène sulfonate de sodium ; et
- 40% d'eau.

Dans tous les cas, un rinçage final à l'eau a permis l'obtention de surfaces exemptes de salissures.

**Revendications**

**1.** Composition de nettoyage se présentant sous la forme d'une microémulsion stable à la température ambiante, ladite composition comprenant :

(A) de l'eau ;
(B) au moins un solvant organique liquide à la température ambiante ; et
(C) au moins un agent tensio-actif, **caractérisée par le fait que** :

(A) représente de 30 à 70 parties en poids ;
(B) représente de 20 à 60 parties en poids ; et
(C) représente de 5 à 30 parties en poids,

(A) + (B) + (C) représentant 100 parties en poids ; et le ou les solvants étant choisis parmi :

(4) les hydrocarbures aliphatiques ;
(5) les hydrocarbures aliphatiques halogénés ;
(6) les hydrocarbures aromatiques ;
(9) les monoéthers des alkylène glycols, des dialkylène glycols et des trialkylène glycols ;
(10) les diéthers des (di)alkylène glycols ; et

(11) les éther acétates des (di)alkylène glycols ; et une partie du constituant (B) étant constituée par au moins l'un parmi les éthers des familles (9), (10) et (11); et le ou les agents tensio-actifs (C) étant choisis parmi ceux de la formule (I) :

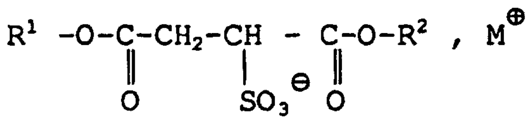 (I)

dans laquelle :

- $R^1$ et $R^2$ représentent chacun indépendamment un radical alkyle, linéaire ou ramifié, en $C_5$-$C_{20}$ ;
- M est un cation choisi parmi $Na^{\oplus}$, $K^{\oplus}$ et $NR_4^{\oplus}$, les R représentant chacun indépendamment hydrogène ou un radical alkyle en $C_1$-$C_4$.

**2.** Composition selon la revendication 1, **caractérisée par le fait que** :

(A) représente 35 à 60 parties en poids;
(B) représente 25 à 55 parties en poids ; et
(C) représente 10 à 25 parties en poids.

**3.** Composition selon l'une des revendications 1 et 2, **caractérisée par le fait que** le ou les solvants organiques (B) sont choisis parmi les hydrocarbures aliphatiques, les hydrocarbures aromatiques, les monoéthers des alkylène glycols, les monoéthers des dialkylène glycols, les monoéthers des trialkylène glycols, les diéthers des alkylène glycols, les diéthers des dialkylène glycols, les éther acétates des alkylène glycols et les éthers acétates des dialkylène glycols.

**4.** Composition selon l'une des revendications 1 à 3, **caractérisée par le fait qu'**elle contient en outre au moins un agent séquestrant, choisi notamment parmi l'acide éthylène diamine tétra acétique et ses sels, à raison notamment de 0,01 à 0,1 partie en poids pour 100 parties en poids de (A) + (B) + (C).

**5.** Composition selon l'une des revendications 1 à 4, **caractérisée par le fait qu'**elle contient en outre au moins un agent chélatant, choisi notamment parmi les éthers couronnes, à raison notamment de 0,01 à 0,1 partie en poids pour 100 parties en poids de (A) + (B) + (C).

**6.** Composition selon l'une des revendications 1 à 5, **caractérisée par le fait qu'**elle contient en outre au moins un agent anti-corrosion, choisi notamment parmi les acides de type $R^*$-COOH, $R^*$ étant un radical hydrocarboné en $C_4$-$C_{24}$, et les amines, à raison notamment de 0,01 à 0,5 partie en poids pour 100 parties en poids de (A) + (B) + (C).

**7.** Composition selon l'une des revendications 1 à 6, **caractérisée par le fait qu'**elle contient en outre au moins un additif choisi parmi les désinfectants, les fongicides, et les biocides.

**8.** Composition selon l'une des revendications 1 à 7, **caractérisée par le fait qu'**elle contient en outre au moins un parfum.

**Patentansprüche**

**1.** Reinigerzusammensetzung in Form einer bei Umgebungstemperatur stabilen Mikroemulsion, wobei die Zusammensetzung umfaßt:

(A) Wasser;
(B) wenigstens ein bei Umgebungstemperatur flüssiges organisches Lösungsmittel; und
(C) wenigstens ein Tensid, **dadurch gekennzeichnet, daß**:

(A) von 30 bis 70 Gew.-teile umfaßt;

(B) von 20 bis 60 Gew.-teile umfaßt; und
(C) von 5 bis 30 Gew.-teile umfaßt,

(A) + (B) + (C) 100 Gew.-teile ergeben; und
das oder die Lösungsmittel ausgewählt ist/sind aus:

(4) aliphatischen Kohlenwasserstoffen;
(5) halogenierten aliphatischen Kohlenwasserstoffen;
(6) aromatischen Kohlenwasserstoffen;
(9) Alkylglycolmonoethern, Dialkylenglycolmonoethern und Trialkylenglycolmonoethern;
(10) (Di)Alkylenglycoldiethern; und
(11) Etheracetaten der (Di)Alkylenglycole; und

ein Teil des Bestandteils (B) aus wenigstens einem der Ether der Familie (9), (10) und (11) gebildet ist; und das oder die Tenside (C) aus denen der Formel I ausgewählt sind:

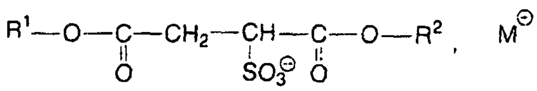

(I)

worin:

- $R^1$ und $R^2$ jeweils unabhängig ein lineares oder verzweigtes $C_5$-$C_{20}$ Alkylradikal darstellen;
- M ein aus $Na^{\oplus}$, $K^{\oplus}$ und $NR_4^{\oplus}$ ausgewähltes Kation ist, wobei die Reste R jeweils unabhängig Wasserstoff oder ein $C_1$-$C_4$ Alkylradikal darstellen.

**2.** Zusammensetzung nach Anspruch 1, **dadurch gekennzeichnet, daß**:

(A) 35 bis 60 Gew.-teile umfaßt;
(B) 25 bis 55 Gew.-teile umfaßt; und
(C) 10 bis 25 Gew.-teile umfaßt.

**3.** Zusammensetzung gemäß einem der Ansprüche 1 und 2, **dadurch gekennzeichnet, daß** das oder die organischen Lösungsmittel (B) ausgewählt ist/sind aus aliphatischen Kohlenwasserstoffen, aromatischen Kohlenwasserstoffen, Alkylenglycolmonoethem, Dialkylenglycolmonoethern, Trialkylenmonoethern, Alkylenglycoldiethem, Dialkylenglycoldiether, Etheracetaten der Alkylenglycole und Etheracetaten der Dialkylenglycole.

**4.** Zusammensetzung gemäß einem der Ansprüche 1 bis 3, **dadurch gekennzeichnet, daß** sie ferner wenigstens einen Komplexbildner enthält, insbesondere ausgewählt aus Ethylendiamintetraessigsäure und deren Salzen, in einem Anteil insbesondere von 0,01 bis 0,1 Gew.-teilen auf 100 Gew.-teile von (A) + (B) + (C).

**5.** Zusammensetzung gemäß einem der Ansprüche 1 bis 4, **dadurch gekennzeichnet, daß** sie ferner wenigstens ein Chelatisierungsmittel enthält, insbesondere ausgewählt aus Kronenethem, in einem Anteil insbesondere von 0,01 bis 0,1 Gew.-teilen auf 100 Gew.-teile von (A) + (B) + (C).

**6.** Zusammensetzung gemäß einem der Ansprüche 1 bis 5, **dadurch gekennzeichnet, daß** sie ferner wenigstens ein Antikorrosionsmittel enthält, insbesondere ausgewählt aus Säuren der Art $R^{\cdot}$-COOH, worin $R^*$ ein $C_4$-$C_{24}$ Kohlenwasserstoffradikal ist, und Aminen, in einem Anteil von insbesondere 0,01 bis 0,5 Gew.-teilen auf 100 Gew.-teile von (A) + (B) + (C).

**7.** Zusammensetzung nach einem der Ansprüche 1 bis 6, **dadurch gekennzeichnet, daß** sie ferner wenigstens ein Additiv enthält, ausgewählt aus Desinfektionsmitteln, Fungiziden und Bioziden.

**8.** Zusammensetzung gemäß einem der Ansprüche 1 bis 7, **dadurch gekennzeichnet, daß** sie wenigstens ein Parfum enthält.

## Claims

1. Cleaning composition which is provided in the form of a microemulsion which is stable at room temperature, the said composition comprising:

   (A) water;
   (B) at least one organic solvent which is liquid at room temperature; and
   (C) at least one surface-active agent,

   **characterized in that**:

   (A) represents from 30 to 70 parts by weight;
   (B) represents from 20 to 60 parts by weight; and
   (C) represents from 5 to 30 parts by weight,

   (A) + (B) + (C) representing 100 parts by weight;
   and
   the solvent or solvents being chosen from:

   (4) aliphatic hydrocarbons;
   (5) halogenated aliphatic hydrocarbons;
   (6) aromatic hydrocarbons;
   (9) alkylene glycol, dialkylene glycol and trialkylene glycol monoethers;
   (10) (di)alkylene glycol diethers; and
   (11) (di)alkylene glycol ether acetates; and

   a portion of component (B) being composed of at least one from the ethers of the families (9), (10) and (11) ; and the surface-active agent or agents (C) being chosen from those of the formula (I):

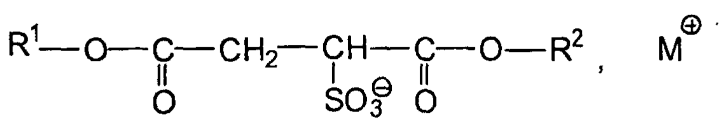

(I)

   in which:

   - $R^1$ and $R^2$ each independently represent a linear or branched $C_5$-$C_{20}$ alkyl radical;
   - M is a cation chosen from $Na^+$, $K^+$ and $NR_4^+$, the R groups each independently representing hydrogen or a $C_1$-$C_4$ alkyl radical.

2. Composition according to Claim 1, **characterized in that**:

   (A) represents 35 to 60 parts by weight;
   (B) represents 25 to 55 parts by weight; and
   (C) represents 10 to 25 parts by weight.

3. Composition according to either of Claims 1 and 2, **characterized in that** the organic solvent or solvents (B) are chosen from aliphatic hydrocarbons, aromatic hydrocarbons, alkylene glycol monoethers, dialkylene glycol monoethers, trialkylene glycol monoethers, alkylene glycol diethers, dialkylene glycol diethers, alkylene glycol ether acetates and dialkylene glycol ether acetates.

4. Composition according to one of Claims 1 to 3, **characterized in that** it additionally comprises at least one sequestering agent, chosen in particular from ethylenediaminetetraacetic acid and its salts, in a proportion in particular of 0.01 to 0.1 part by weight per 100 parts by weight of (A) + (B) + (C).

5. Composition according to one of Claims 1 to 4, **characterized in that** it additionally comprises at least one chelating

agent, chosen in particular from crown ethers, in a proportion in particular of 0.01 to 0.1 part by weight per 100 parts by weight of (A) + (B) + (C).

6. Composition according to one of Claims 1 to 5, **characterized in that** it additionally comprises at least one corrosion inhibitor, chosen in particular from acids of R°-COOH type, R° being a $C_4$-$C_{24}$ hydrocarbonaceous radical, and amines, in a proportion in particular of 0.01 to 0.5 part by weight per 100 parts by weight of (A) + (B) + (C).

7. Composition according to one of Claims 1 to 6, **characterized in that** it additionally comprises at least one additive chosen from disinfectants, fungicides and biocides.

8. Composition according to one of Claims 1 to 7, **characterized in that** it additionally comprises at least one fragrance.